# EUROPEAN PATENT SPECIFICATION

(11) **EP 0 305 975 B1**
(45) Date of publication and mention of the grant of the patent: **13.10.1993**
(21) Application number: 88114148.5
(22) Date of filing: 30.08.1988
(51) Int. Cl.: H01L 29/812, H01L 29/10

(54) **Compound semiconductor MESFET**
Verbindungshalbleiter-MESFET
MESFET à semi-conducteur composé

(30) Priority: 31.08.1987 JP 217264/87
(43) Date of publication of application: 08.03.1989
(73) Proprietor: KABUSHIKI KAISHA TOSHIBA, Kawasaki-shi, Kanagawa-ken 210 (JP)
(72) Inventor: Suga, Toru Patent Division, Tokyo 105 (JP); Tomisawa, Yutaka Patent Division, Tokyo 105 (JP)
(74) Representative: Henkel, Feiler, Hänzel & Partner

(56) References cited:
- IEEE ELECTRON DEVICE LETTERS, vol. EDL-6, no. 2, February 1985, pages 97-99, New York, US ; A.S. BLUM et al. :"Use of a Surrounding p-Type Ring to Decrease Backgate Biasing in GaAs MESFET's"
- PATENT ABSTRACTS OF JAPAN, vol. 10, no. 224 (E-425)(2280), 5th August 1986 ; & JP-A-6161473 (NEC), 29.03.1986
- PATENT ABSTRACTS OF JAPAN, vol. 10, no. 32 (E-379)(2089), 7th February 1986 ; & JP-A-60189250 (FUJITSU), 26-09-1985

## Description

The present invention relates to a semiconductor device of the compound semiconductor type, and more particularly to a GaAs metal semiconductor field effect transistor (MES FET).

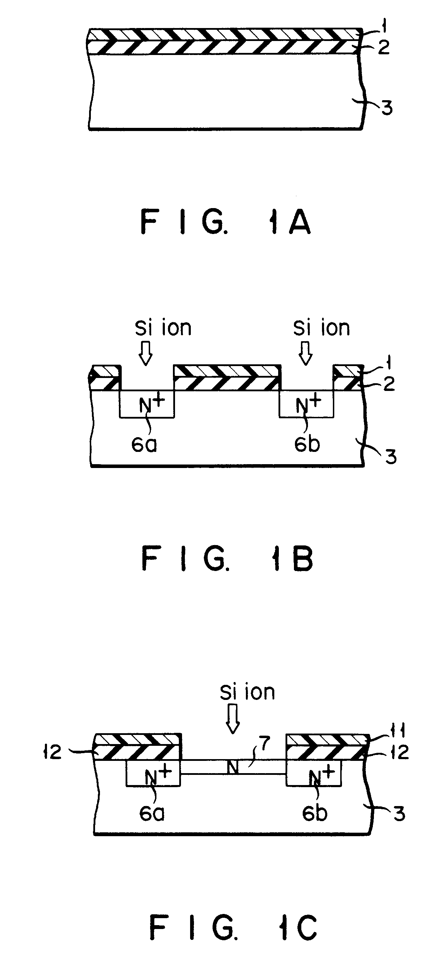

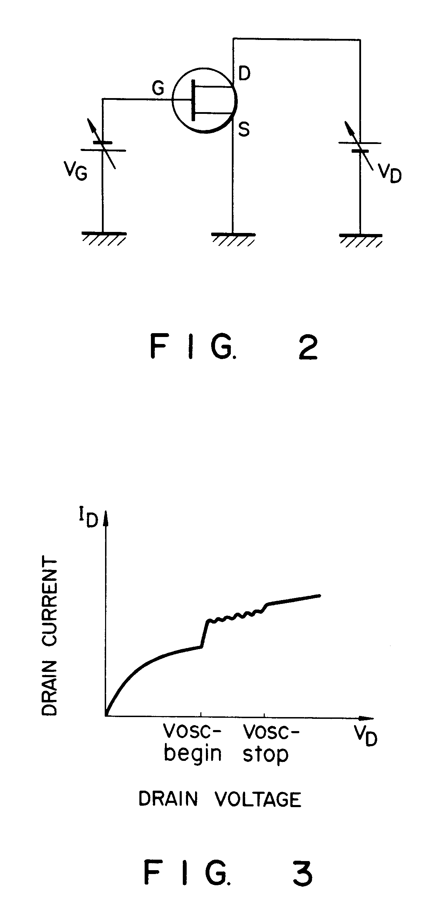

For a closer look at the structure of the GaAs MES FET, how the MES FET is manufactured will first be discussed. Figs. 1A through 1F show a sequence of process steps to manufacture the GaAs MES FET by the ion implantation process technique.

To start (see Fig. 1A), SiO₂ film 2, 300 nm (3000 Å) thick, is formed on GaAs monocrystal substrate 3 not doped with an impurity, by a chemical vapor deposition (CVD) method. To form resist film 1, photoresist is applied to the formed SiO₂ film 2. In a second step of process (Fig. 1B), resist layer 1 and SiO₂ film 2 are patterned to open the portions of these layers 1 and 2 right above the regions in substrate 3 where drain and source regions 6a and 6b are to be formed. Through the formed openings, silicon ions are implanted into these regions in substrate 3, at a proper acceleration voltage and a proper dosage of silicon ions. To effect this process step, the lithography process and the photoetching process are used. In a third process step (Fig. 1C), after the patterned resist layer 1 and SiO₂ film 2 are stripped from substrate 3, the above process is repeated to form SiO₂ film 12 and resist layer 11 on substrate 3, and to pattern the oxide film and the resist layer with an opening defining a surface area of substrate 3 under which a channel layer 7 is to be formed. Through this opening, silicon ions are implanted into that region of substrate 3 at a proper acceleration voltage and a dosage of silicon ions.

The structure thus formed is thermally processed in a diluted arsine gas (AsH3), to activate the doped silicon ions and to form drain and source layers 6a and 6b, and N channel layer 7.

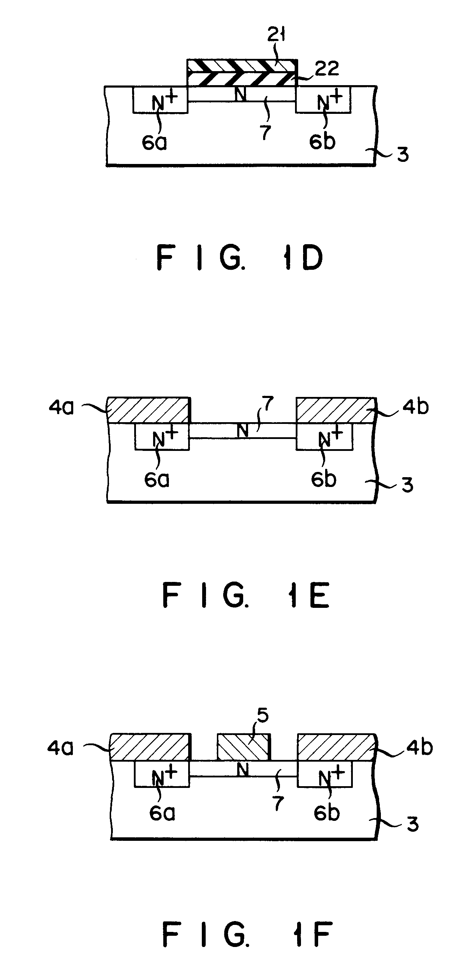

After removal of oxide film 12 from substrate 13, the above process is again applied to form SiO₂ film 22 and resist layer 21 and to pattern them with openings to define the portions of the structure surface on which drain and source electrodes 14a and 14b are to be formed (Fig. 1D). Gold-Germanium alloy is vapor-deposited on the structure. Following this, the oxide film 22 and resist layer 21 are stripped off the structure, so that drain and source electrodes 14a and 4b are formed as shown in Fig. 1E. The structure is subjected to the thermal process for alloying to form ohmic contacts between drain electrode 4a and drain layer 6a, and source electrode 4b and source layer 6b. On the structure, a Schottky barrier electrode 5 must be formed to complete a GaAS MES FET. To achieve this step of process, an SiO₂ film (not shown) patterned so as to have an opening for forming the gate electrode is formed by using the foregoing step again. Titanium Ti and aluminum Aℓ are deposited on the structure in this order. The lift-off process is followed to remove the insulating film with the deposited Ti and Aℓ thereover, to form the gate electrode 5 on channel layer 7 (see Fig. 1F).

The MES FET thus formed is assembled into a circuit applied to the gate, a positive voltage is applied to the drain, and the source is grounded. A variation of the drain current ID of the FET against a change of the drain voltage VD is measured by a parameter analyzer. The variation of the drain current ID is plotted as shown in Fig. 3. As seen from the ID - VD curve, when the FET is operated at the gate voltage near the pinchoff gate voltage that the depletion layer of the Schottky barrier reaches the bottom of channel layer 7, the drain current instably varies like oscillation. This oscillation phenomenon is observed in the vicinity of the pinch-off voltage, and as seen from the illustrated curve, occurs in the range from Vosc-begin to Vosc-stop in Fig. 3. This phenomenon implies that when the MES FET is operated at a specific gate voltage or its near voltage, i.e., the pinch-off gate voltage or its near voltage, the noise increases. Further, this implies that when a number of FETs as logical elements are fabricated into a wafer or wafers, the Vosc-begin and/or Vosc-stop points of the fabricated FETs is not uniform.

Another problem of the GaAs MES FET is known as a back-gate or side-gate phenomenon in which the drain current ID changes when the FET is biased at the rear portion of the substrate or the side portion of the device. This phenomenon is discussed in details by Christopher Kocot & Charles A. Stolte in their paper of IEEE TRANS. ELECTRON DEVICES, Vol., ED-29, 1982, pp 1059 to 1064. This phenomenon is problematic when a number of semicon-ductor elements are integrated into a wafer, because the operating characteristics of the FETs are adversely influenced by the potentials of the electrodes of the adjacent FETs.

Yet another problem of the GaAs MES FET is to manufacture these MES FETs with uniform threshold voltages when these are integrated into a wafer for wafers. This is owing to the fact that the difference between the logical amplitudes for on and off is very small, and a tolerable range of the threshold voltage Vth is considerably narrow.

Prior art documents Patent Abstracts of Japan, Vol. 10, No. 224 (E-425) (2280) August 5, 1986 & JP-A-61-61473 discloses a field effect type element which uses a control electrode region for varying a potential near a channel. This control electrode region is Schottky- contacted with aluminium out of an element on the p-type GaAs. A negative voltage Vo is applied to this control electrode region to deepen a potential well, and charge carriers can move between source and drain electrode regions while holding the state that enclosed in a quasi-secondary potential well. In this way, a field effect type element is obtained which has a hetero junction including high speed and excellent low noise by forming this control electrode region 47 for controlling the voltage near a current passage of the region between a gate region and a drain electrode region from the opposite side of the gate electrode region with respect to the current passage.

Further, prior art document IEEE Electron Device Letters EDL-60, 97-99, discloses a semiconductor device comprising two MESFETs which are backgate biased by a p-region or a n-region.

It is an object of the present invention to provide a semiconductor device of the compound type which is free from the oscillation phenomenon as observed on the ID - VD curve, can suppress the backgate effect satisfactorily, and enables the threshold voltage to be precisely controlled, and hence can provide a uniformity in the threshold voltages when a number of FETs are integrated into a wafer or wafers.

To solve this object the present invention provides a semiconductor device as specified in claim 1.

According to the present invention, there is provided a semiconductor device of the compound semiconductor type with the following structure. A first semiconductor layer doped with an impurity, i.e., a back-gate effect suppression layer, is provided right under a channel layer. The impurity as dopant is of a first conductivity type. The channel layer is of a second conductivity type. These first and second conductivity types are opposite to each other. A control electrode is formed on the substrate, which is in ohmic contact with the back-gate effect suppression layer via a second highly concentrated semiconductor layer of the second conductivity, so as to control the potential of the back-gate effect suppression layer.

With such a structure of the semiconductor device, in operation, a predetermined fixed voltage is applied to the control electrode, and hence the back-gate effect suppression layer is impressed with the fixed voltage. Therefore, the back-gate effect can be suppressed to a minimum. The instable behavior like oscillation as observed in the vicinity of the pinch-off voltage can be prevented. A number of semiconductor devices with uniform threshold voltages Vth can be integrated into a wafer or wafers.

The control electrode may electrically be connected to any of other electrodes. Selection of either of these depends on the layout of passive and active elements around the semiconductor device on the wafer, and the operating conditions of these elements.

This invention can be more fully understood from the following detailed description when taken in conjunction with the accompanying drawings, in which:
Figs. 1A through 1F show sectional views illustrating a sequence of process steps to manufacture a prior GaAs MES FET;
Fig. 2 shows a circuit diagram of a circuit used for measuring the ID - VD characteristic curve of the MES FET manufactured by the process of Fig. 1;
Fig. 3 shows a graph illustrating the ID - VD curve measured by using the Fig. 2 circuit;
Fig. 4A shows a top view illustrating a pattern of a GaAs MES FET incorporating the present invention;
Fig. 4B shows a sectional view of the MES FET taken on line IVB - IVB in Fig. 4A;
Figs. 5A through 5J show sectional and plan views illustrating a sequence of process steps to manufacture the MES FET of Fig. 4;
Fig. 6 shows a graphical representation of the ID - VD characteristic of the Fig. 4 MES FET;
Fig. 7A shows a top view illustrating a pattern of a GaAs MES FET according to another embodiment of the present invention;
Fig. 7B shows a sectional view of the MES FET taken on line VIIB - VIIB in Fig. 7A;
Fig. 8A shows a top view illustrating a pattern of a GaAs MES FET according to a further embodiment of the present invention; and
Fig. 8B shows a sectional view of the GaAs MES FET shown in Flg. 10A.

Preferred embodiments of a semiconductor device according to the present invention will be described referring to the accompanying drawings. In the description to follow, the present invention is embodied into GaAs MES FETs, by way of example.

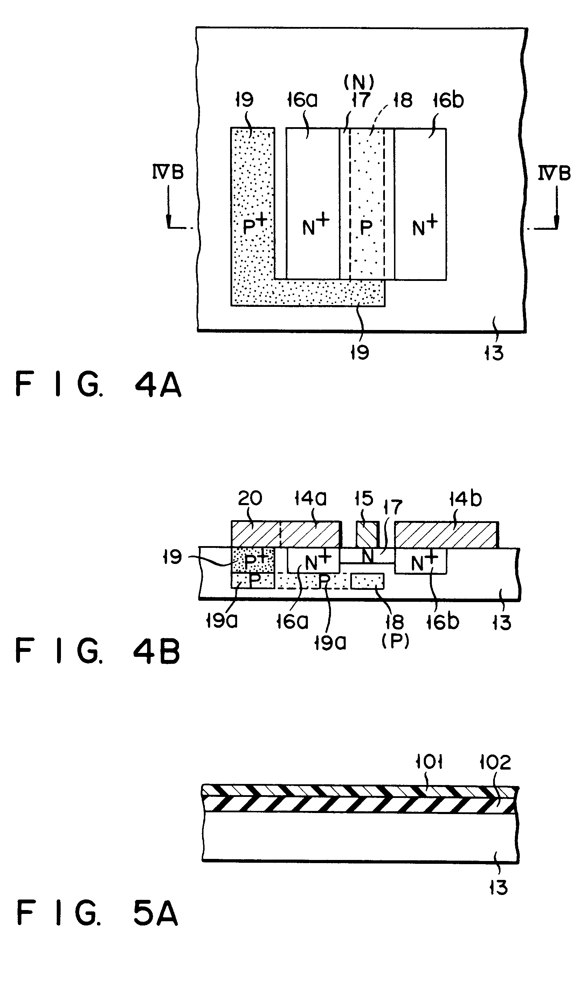

Reference is first made to Figs. 4A and 4B cooperatively showing the structure of a model of the MES FET incorporating the present invention. Fig. 4A shows a plan view of the MES FET, and Fig. 4B a sectional view of the same taken on line IVB - IVB in Fig. 4A. As shown, N channel layer 17, and N⁺ drain layer 16a at high impurity concentration and N⁺ source layer 16b also heavily doped with an impurity are formed in the surface region of GaAs substrate 13. In the surface region, channel layer 17 is located between drain and source layers 16a and 16b. Back-gate effect suppression layer 18 is located right under channel layer 17 in the surface region of substrate 13. P⁺ conductive layer 19 serving as a wiring layer is further formed in the surface region of substrate 13. Control electrode 20, which is formed on substrate 13, makes an ohmic contact with back-gate effect suppression layer 18, via conductive wiring layer 19. In this instance, control electrode 20 and drain electrode 14a are formed by a single metal film made of gold-germanium alloy, for example, and are electrically interconnected. In Fig. 4A, the electrodes are not shown for simplicity of illustration. In Fig. 4B, the horizontal leg portion of L-shaped conductive layer 19 (Fig. 4A) is indicated by broken lines.

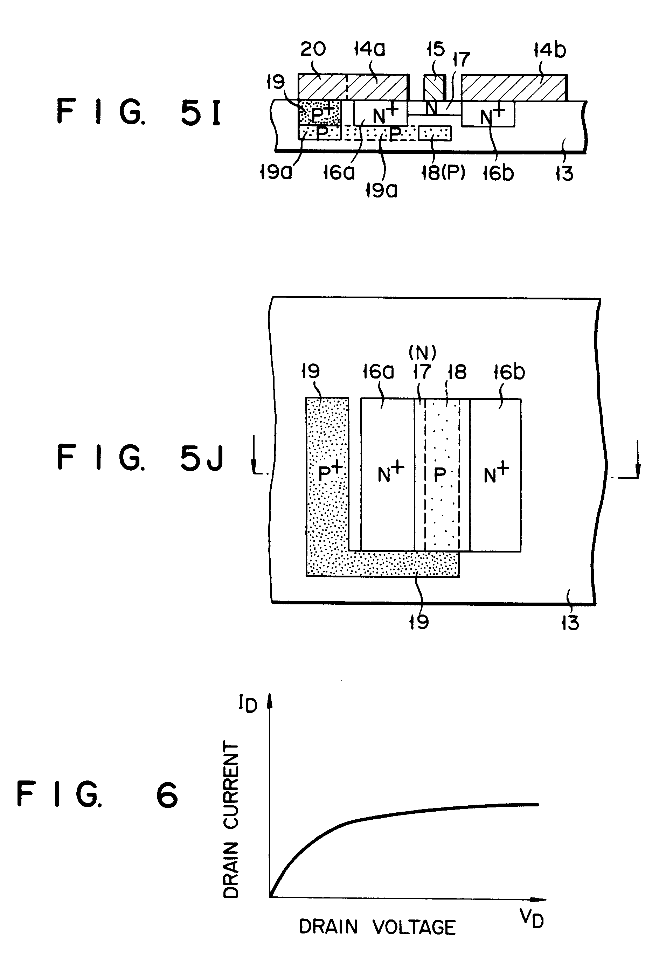

A sequence of process steps for manufacturing the MES FET will be described referring to Figs. 5A to 5J.

### PROCESS 1 (Fig. 5A)

SiO₂ film 102 of 500 nm (5000 Å) in thick is formed on GaAs substrate 13 by CVD process. Photoresist is coated on SiO₂ film 102 to form resist film 11 thereon.

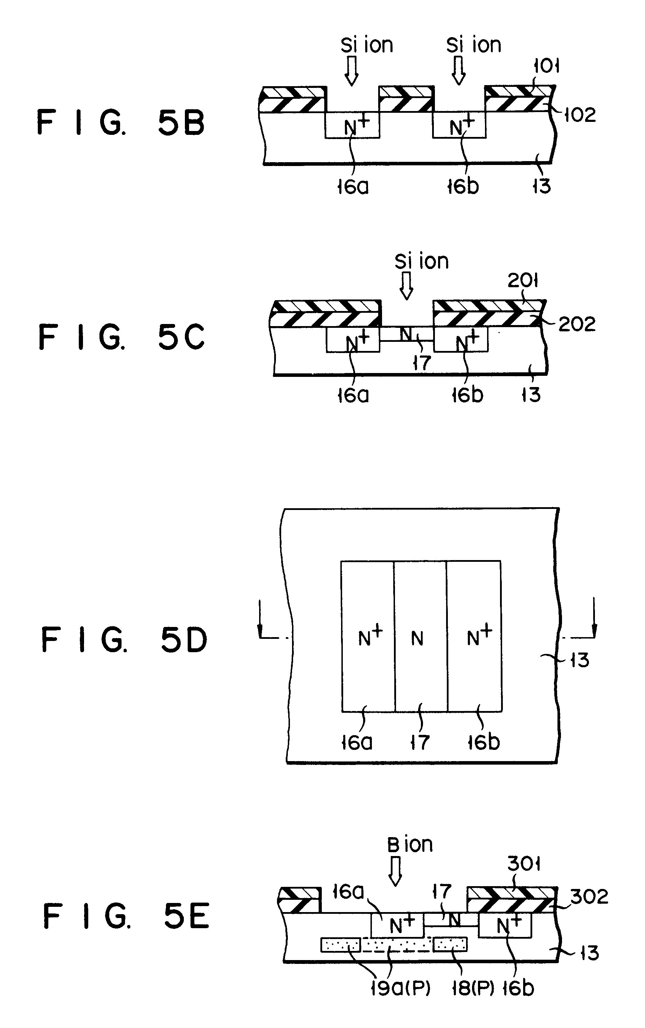

### PROCESS 2 (Fig. 5B)

Resist film 101 is patterned into a resist pattern with openings at required locations by lithographic process. By using the formed resist pattern as a mask, SiO₂ film 102 is selectively etched away, to form openings, which will be used for forming drain and source layers 16a and 16b at predetermined locations. Through the formed openings, silicon ions are implanted into the regions in the substrate surface region as defined by the opening, two times. The first time ion implanting conditions are: acceleration voltage is 180 keV, and dosage of silicon ions is 4 x 10¹³ cm⁻². The second time ion implanting conditions are: acceleration voltage is 100 keV and dosage of silicon ions is 2 x 10¹³ cm⁻².

### PROCESS 3 (Figs. 5C and 5D)

Resist film 101 and SiO₂ film 102 are removed from the structure. Another SiO₂ film 202 and another resist film 201 with a pattern having openings at predetermined locations are successively formed on the structure by the process steps similar to the above ones. Then, through the opening, silicon ions are implanted into substrate 13, thereby to form N channel layer 17. The conditions for forming the channel layer are: acceleration voltage is 100 keV, and dosage of silicon ions is 3 x 10¹² cm⁻². Although Fig. 5D shows a plan view of the structure of the MES FET shown in 5C, resist film 201 and SiO₂ film 202 are not illustrated therein for simplicity of illustration. These films will be omitted in the related illustrations to follow, for the same purposes.

### PROCESS 4 (Figs. 5E and 5F)

Resist film 201 and SiO₂ film 202 are removed from the structure. Another SiO₂ film 302 and another resist film 301 with a pattern having openings at predetermined locations are successively formed on the structure by the process steps similar to the above ones. Then, through the opening, P type impurity as acceptor impurity, such as C, Be, Mg or B, is implanted into substrate 13. When boron B is used, the implanting conditions are: acceleration voltage is 400 keV, and dosage of boron ions is 3 x 10¹³ cm⁻². As a result, boron ions are doped into continuous regions 18 and 19a. Region 18 is to serve as the back-gate effect suppression layer and is right under the channel layer 17 located between source layer 16b and drain layer 16a. Region 19a is to serve as a part of the conductive wiring layer. Incidentally, Fig. 5F shows a plan view of the structure of Fig. 5E.

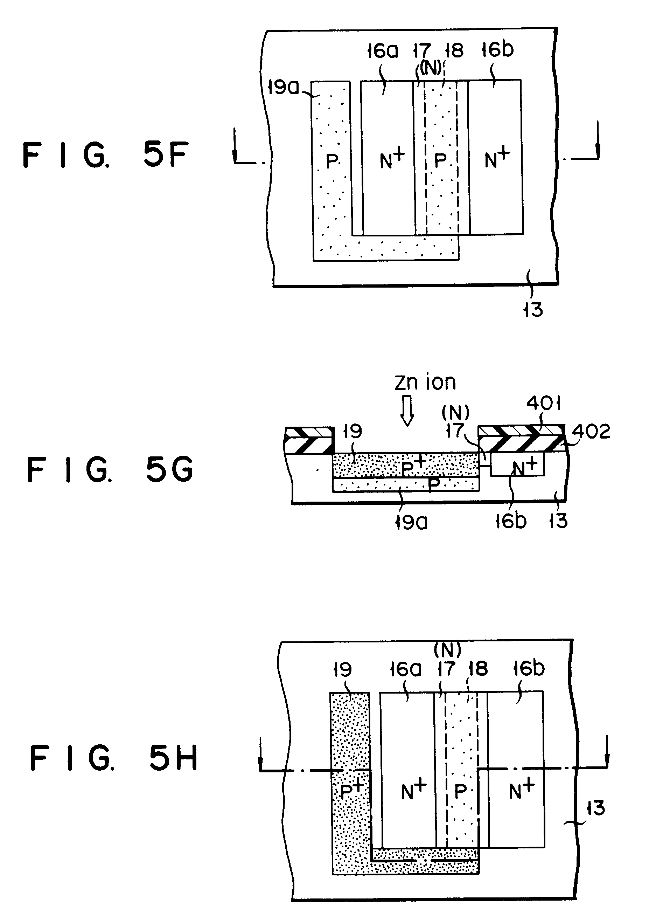

### PROCESS 5 (Figs. 5G and 5H)

Resist film 301 and SiO₂ film 302 are removed from the structure. Another SiO₂ film 402 and another resist film 401 with a pattern having openings at predetermined locations are successively formed on the structure by the process steps similar to the above ones. Then, through the opening, zinc ions are implanted into substrate 13 at 100 keV of accelerating voltage and 5 x 10¹⁴ cm⁻² of dosage. As a result, zinc Zn doped layer 19 is formed in the substrate. This layer 19 serves as a wiring layer in ohmic contact with a control electrode to be formed in a subsequent step of process. Wiring layer 19 comprises region 19a and a region continuous to this region 19a and extending up to the surface of substrate 13. This extending region serves as a lead layer for wiring layer 19. A control electrode is formed on the lead layer in a subsequent process step. Fig. 5H is a top view of the Fig. 5G structure.

### PROCESS 6 (Figs. 5I and 5J)

Resist film 401 and SiO₂ film 402 are removed from the structure. Subsequently, the structure is thermally processed in AsH₃ as at 850°C, for 15 minutes, to activate doped ions. Subsequently, the following steps are successively executed; a step to form an SiO₂ film on the structure by CVD process, a step to form a predetermined pattern of the SiO₂ by lithography process, a step to form drain electrode 14a and source electrode 14b on substrate 13 by vapor-depositing a metal, e.g., Au-Ge alloy, and a step to lift off the patterned SiO₂ film used as a mask layer. Through the above steps of process, drain electrode 14a, source electrode 14b, and control electrode 20 are formed on the predetermined locations of the structure. Control electrode 20 is continuous to drain electrode 14a, and is in ohmic contact with wiring layer 19. Finally, gate electrode 15 is formed on the channel layer 17 of the structure. The Schottky barrier is formed at the junction of gate electrode 15 and channel layer 17. The process to form gate electrode 15 is substantially the same as that to form drain and source electrodes 14a and 14b and gate electrode 20, except that aluminum Aℓ is first deposited up to 700 nm (7000 Å) thick, and titanium Ti is further deposited on the Aℓ deposited layer to form a Ti layer of 300 nm (3000 Å) in thick. Fig. 5J shows a top view of the Fig. 5I structure. In this way, the MES FET fabrication is completed.

In the MES FET thus formed, a single layer is used for both control electrode 20 and drain electrode 14a, to set the potential of back-gate effect suppression layer 18 at the drain potential. Therefore, the ID - VD characteristic curve smoothly varies in the vicinity of the pinch-off voltage, as shown in Fig. 6, while in the prior art MES FET, the oscillation phenomenon occurs near the pinch-off voltage, as shown in Fig. 3.

In the MES FET thus structured, little back-gate effect is observed. Further, according to the present invention, MES FETs can be formed in the same wafer and in different wafers under such a precise control that the threshold voltage Vth of the FETs are substantially uniform in value.

The article referred to in the prior art description explains that the oscillation phenomenon inevitable for the GaAs MES FET is probably due to instable electron trapping by a large barrier (e.g., EL-2) existing in the interface between the channel and the semiconductor substrate. However, the exact cause for the oscillation phenomenon is unknown yet. In the embodiment as mentioned above, the potential of the back-gate effect suppression layer formed under the channel layer is fixed to the drain electrode potential, as already stated. Therefore, there is eliminated the oscillating phenomenon as observed in the vicinity of the pinch-off voltage of the prior art FET. Additionally, the present invention has successfully solved the problem that when a number of FETs are integrated into a wafer or wafers, the electrodes of the FETs adversely affects an FET located near and around the electrodes.

While the present invention is applied for the N channel MES FET in the embodiment as mentioned above, it may be applied to the P channel MES FET. In this case, the conductivity type of the doped impurity used is opposite to that of the N channel MES FET. More exactly, arsenic As or phosphorous P is used in place of boron B.

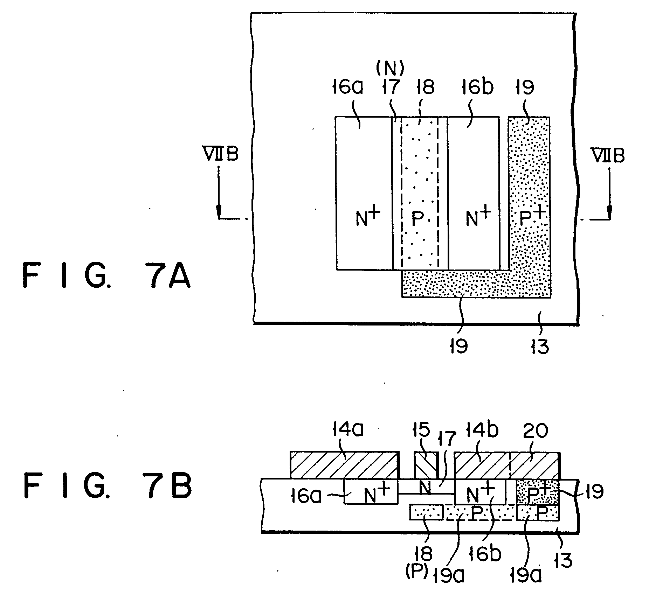

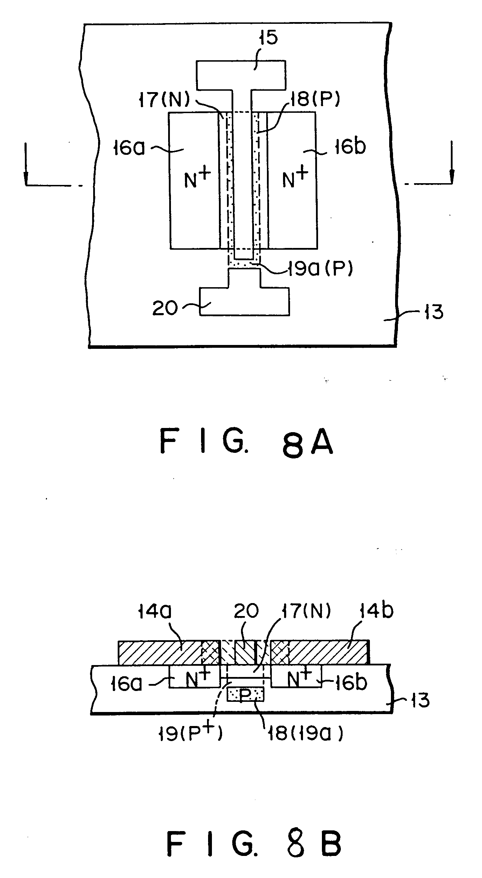

As shown in Figs. 7A and 7B, control electrode 20 may be connected to source electrode 14b, not drain electrode 14a. A proper potential is applied to control electrode 20. Control electrode 20 may be connected to gate electrode 15, as shown in Figs. 8A and 8B.

As described above, the back-gate effect suppression layer, which is doped with the impurity whose conductivity is opposite to that of the channel layer, is formed under the channel layer. The potential of the back-gate effect suppression layer is fixed to a desired potential, via the wiring layer heavily doped with impurities and the control gate in ohmic contact with the wiring layer. With this feature, the back-gate or side-gate effect problem may successfully be solved, which is the inevitable problem for the prior art FETs. Further, the oscillating phenomenon as observed on the ID - VD curve of the prior art FET in the vicinity of the pinch-off voltage, may also be suppressed to be negligible. Furthermore, a number of FETs may be formed in a wafer or wafers, with substantially uniform values of their threshold voltages Vth.

## Claims

1. A semiconductor device comprising:
a channel layer (17) of a first conductivity type, a source layer (16a) and a drain layer (16b) formed in the surface region of a compound semiconductor substrate (13), said source and drain regions (16a, 16b) having a high impurity concentration and being of the first conductivity type, said channel layer (17) being located between said source and drain layers (16a, 16b);
a gate electrode (15) formed on said substrate (13), said gate electrode (15), together with said channel layer (17), forming a Schottky barrier;
source and drain electrodes (14a, 14b) in ohmic contact with said source and drain layers (16a, 16b), and
a first semiconductor layer (18) of a second conductivity type opposite to the first conductivity type, said first semiconductor layer (18) being formed right under said channel layer (17), and doped with an impurity;
characterized by
a second heavily doped semiconductor layer (19) of the second conductivity type, said second semiconductor layer (19) being formed in the surface region of said substrate (13); and
a control electrode (20) formed on said substrate (13), said control electrode (20) being connected to one of said drain electrode (14b), said source electrode (14a) and said gate electrode (15) and in ohmic contact with said first semiconductor layer (18) via said second semiconductor layer (19).

2. A semiconductor device according to claim 1, characterized in that said control electrode (20) is in proximity with said drain electrode (14a).

3. A semiconductor device according to claim 1, characterized in that said control electrode (20) is in proximity with said source electrode (14b).

## Patentansprüche

1. Halbleiterbauelement, das folgendes umfaßt:
eine Kanalschicht (17) eines ersten Leitfähigkeitstyps, eine im Oberflächenbereich eines Verbindungs-Halbleitersubstrats (13) ausgebildete Sourceschicht (16a) und eine Drainschicht (16b), wobei die Source- und Drainzonen (16a, 16b) eine hohe Dotierungsstoffkonzentration aufweisen und vom ersten Leitfähigkeitstyp sind, und wobei die Kanalschicht (17) zwischen der Soruce- und Drainschicht (16a, 16b) angeordnet ist;
eine auf dem Substrat (13) ausgebildete Gateelektrode (15), wobei die Gatelektrode (15) zusammen mit der Kanalschicht (17) eine Schottky-Barriere bildet;
in ohmschen Kontakt mit den Source- und Drainschichten (16a, 16b) stehende Source- und Drainelektroden (14a, 14b), und
eine erste Halbleiterschicht (18) eines zweiten dem ersten Leitfähigkeitstyp entgegegengesetzten Leitfähigkeitstyps, wobei diese erste Halbleiterschicht (18) unmittelbar unterhalb der Kanalschicht (17) ausgebildet und mit einem Dotierungsstoff dotiert ist;
gekennzeichnet durch
eine zweite hochdotierte Halbleiterschicht (19) des zweiten Leitfähigkeitstyps, wobei die zweite Halbleiterschicht (19) im Oberflächenbereich des Substrats (13) ausgebildet ist; und
eine auf dem Substrat (13) ausgebildete Steuerelektrode (20), wobei diese Steuerelektrode (20) entweder mit der Drainelektrode (14b), der Sourceelektrode (14a) oder der Gateelektrode (15) verbunden ist und über die zweite Halbleiterschicht (19) in ohmschen Kontakt mit der ersten Halbleiterschicht (18) steht.

2. Halbleiter-Bauelemente gemäß Anspruch 1, dadurch gekennzeichnet, daß sich die Steuerelektrode (20) in der Nähe der Drainelektrode (14a) befindet.

3. Halbleiter-Bauelemente gemäß Anspruch 1, dadurch gekennzeichnet, daß sich die Steuerelektrode (20) in der Nähe der Sourceelektrode (14a) befindet.

## Revendications

1. Dispositif à semi-conducteur, comprenant :
une couche (17) de canal d'un premier type de conductivité, une couche (16a) de source et une couche (16b) de drain formées sur la région de la surface d'un substrat (13) d'un composé semi-conducteur, les régions de source et de drain (16a, 16b) ayant une concentration élevée d'impureté et étant du premier type de conductivité, la couche de canal (17) étant placée entre les couches de source et de drain (16a, 16b),
une électrode (15) de grille formée sur le substrat (13), l'électrode (15) de grille formant, avec la couche (17) de canal, une barrière de Schottky,
des électrodes de source et de drain (14, 14b) qui sont en contact ohmique avec les couches de source et de drain (16a, 16b), et
une première couche semi-conductrice (18) du second type de conductivité opposé au premier type de conductivité, la première couche semi-conductrice (18) étant formée juste au-dessous de la couche de canal (17) et étant dopée par une impureté, caractérisé par :
une seconde couche semi-conductrice très dopée (19) ayant le second type de conductivité, la seconde couche semi-conductrice (19) étant formée dans la région de la surface du substrat (13), et
une électrode (20) de commande formée sur le substrat (13), l'électrode de commande (20) étant connectée à l'une des électrodes de drain (14b), de source (14a) et de grille (15) et étant en contact ohmique avec la première couche semi-conductrice (18) par l'intermédiaire de la seconde couche semi-conductrice (19).

2. Dispositif à semi-conducteur selon la revendication 1, caractérisé en ce que l'électrode de commande (20) est à proximité de l'électrode de drain (14a).

3. Dispositif à semi-conducteur selon la revendication 1, caractérisé en ce que l'électrode de commande (20) est à proximité de l'électrode de source (14b).
